# EUROPÄISCHE PATENTSCHRIFT

(11) **EP 3 469 605 B1**
(45) Veröffentlichungstag und Bekanntmachung des Hinweises auf die Patenterteilung: **14.10.2020**
(21) Anmeldenummer: 17726589.9
(22) Anmeldetag: 22.05.2017
(51) Int. Cl.: H01C 7/12, H01H 37/76

(54) **ÜBERSPANNUNGSSCHUTZANORDNUNG MIT MEHREREN, AUF EINER ERSTEN SEITE EINER N-ECKIGEN TRÄGERPLATTE ANGEORDNETEN, SCHEIBENFÖRMIGEN VARISTOREN**
OVERVOLTAGE PROTECTION ARRANGEMENT HAVING A PLURALITY OF PLANAR VARISTORS ARRANGED ON A FIRST SIDE OF AN N-CORNERED SUPPORTING PLATE
DISPOSITIF DE PROTECTION CONTRE LES SURTENSIONS COMPORTANT PLUSIEURS VARISTANCES EN FORME DE DISQUE DISPOSÉS SUR UN PREMIER CÔTÉ D'UNE PLAQUE DE SUPPORT À N CÔTÉS

(30) Priorität: 10.06.2016 DE 102016007131; 29.12.2016 DE 102016015593
(43) Veröffentlichungstag der Anmeldung: 17.04.2019
(73) Patentinhaber: DEHN SE + Co KG, 92318 Neumarkt / Opf. (DE)
(72) Erfinder: LI, Hongjun, Shanghai 201109 (CN); XU, Niansheng, Shanghai 201199 (CN); CHEN, Weie, Shanghai 201101 (CN)
(74) Vertreter: Kruspig, Volkmar
(86) Internationale Anmeldenummer: PCT/EP2017/062247
(87) Internationale Veröffentlichungsnummer: WO 2017/211578

(56) Entgegenhaltungen:
- EP-A1- 2 294 589
- DE-A1-102013 006 052
- DE-B3-102015 000 329
- DATABASE WPI Week 201477 Thomson Scientific, London, GB; AN 2014-V00350 XP002773115, -& CN 104 008 936 A (SICHUAN ZHONGGUANG LIGHTING PROOF TECHN) 27. August 2014 (2014-08-27)

## Beschreibung

Die Erfindung betrifft eine Überspannungsschutzanordnung mit mehreren, auf einer ersten Seite einer n-eckigen Trägerplatte angeordneten, scheibenförmigen Varistoren, mindestens einem Gasableiter sowie mindestens einer Thermosicherung oder thermischen Abtrenneinrichtung, welche mit mindestens einem der Varistoren in engem thermischen Kontakt steht, wobei die vorgenannten Bauteile von einem Außengehäuse umgeben und weiterhin auf der zweiten Seite der Trägerplatte Mittel zum elektrischen Anschluss zum Verlöten auf einer Leiterplatte vorgesehen sind, gemäß Oberbegriff des Anspruchs 1.

Aus der CN000204668940U ist eine in einem Gehäuse befindliche Überspannungsschutzanordnung vorbekannt, wobei die Anordnung drei, räumlich in Reihe angeordnete scheibenförmige Varistoren umfasst.

Zwischen mindestens zwei der räumlich in Reihe angeordneten scheibenförmigen Varistoren ist eine Thermosicherung befindlich, welche in einem engen thermischen Kontakt zum jeweiligen Varistor steht.

Die räumliche Reihenschaltung umfasst darüber hinaus einen Gasentladungsableiter.

Bedingt durch die Anordnung der Thermosicherung innerhalb der Sandwich-Konstruktion der Varistoren kann nur der jeweils benachbarte Varistor hinsichtlich seines thermischen Verhaltens überwacht werden. Eine Überprüfung des Zustands des eingesetzten Gasableiters ist nicht möglich. Weiterhin führt die SandwichAnordnung der Varistoren zu Problemen beim Erreichen oder Sicherstellen notwendiger elektrischer Trennungsabstände.

Ganz grundsätzlich kann die Wärmeenergie der thermisch zu überwachenden Varistoren gemäß dem geschilderten Stand der Technik nur unzureichend und nicht schnell genug zu den thermischen Sicherungen transportiert werden.

Aus der DE 10 2013 005 327 A1 ist eine Überspannungsschutzanordnung mit mehreren scheibenförmigen Varistoren vorbekannt.

Diese scheibenförmigen Varistoren sind innerhalb eines, einen Hohlraum einschließenden Gehäuses angeordnet und elektrisch kontaktiert.

Dieses vorbekannte Gehäuse ist als Vieleckkörper, insbesondere mehrseitiges Prisma, Würfel, Quader oder Tetraeder ausgebildet und weist eine Öffnung zum Einbringen der scheibenförmigen Varistoren auf, welche jeweils mit einem Abschnitt oder einem Teil der Gehäuseinnenseitenwandung mechanisch in Verbindung stehen und dort in Anlage kommen. Über das Gehäuse kann eine elektrische Kontaktierung zur gewünschten Parallelschaltung der eingesetzten Varistoren vorgenommen werden. Darüber hinaus schaffen großflächige Verbindungen und das diesbezügliche Inkontaktkommen der Varistoren mit der Gehäuseseitenwand einen guten thermischen Übergang zum Zweck des Ableitens von Verlustwärme.

Zum Stand der Technik sei noch auf die DE 37 34 214 C2 verwiesen. Dieses Dokument zeigt eine Anordnung mit einem Varistor, wobei zur Abschaltung des Varistors von einer Spannungsquelle bei dessen Überhitzung die auf beiden Stirnseiten des Varistors vorgesehenen Kontaktflächen mit Zu- und Ableitungen der Spannungsquelle verbunden sind und wobei in einer dieser Leitungen in Varistornähe eine Lotstelle vorgesehen ist. Der Varistor selbst befindet sich in einem napfförmigen Gehäuse, wobei die erste seiner Kontaktflächen an der Innenseite der Gehäusebodenfläche anliegt und das Gehäuse einen Anschluss bildet bzw. aufweist. Die zweite Seite der Kontaktfläche des Varistors ist mit einer Isoliermasse abgedeckt, wobei eine elektrisch und thermisch leitende Verbindung durch die Isoliermasse hindurch zur Lotstelle besteht. Die Lotstelle und die einen Anschluss bildende Verbindung befinden sich an der dem Varistor abgewandten Oberfläche der Isoliermasse. Eine federnde Kontaktzunge der derart gebildeten thermischen Abtrennvorrichtung ist als Spiralfeder ausgebildet, wobei das äußere Ende dieser Spirale über die Lotstelle mit dem zugehörigen Anschluss und das innere Ende dieser Spirale mit dem zugehörigen Gegenanschluss verbunden ist.

Das Dokument CN 104 008 936 A beschreibt eine Überspannungsschutzanordnung mit mehreren Varistoren, mit einem Gasableiter und mit thermischen Abtrenneinrichtungen, die einen isolierenden Schieber aufweisen.

Im Rahmen einer zunehmenden Integration von Baugruppen und Bauteilen auf Leiterplattenebene entstehen Probleme bei der Anordnung und Einbindung von Überspannungsschutzgeräten in derartige elektronische Einrichtungen. Die Überspannungsschutzgeräte müssen insofern von ihrem Bauraum möglichst klein ausgeführt werden und sollen zur unmittelbaren Leiterplattenmontage geeignet sein. Weiterhin besteht die Notwendigkeit, trotz geringer Abmessungen und einer recht hohen Packungsdichte die notwendigen elektrischen Trennungsabstände einzuhalten. Letztendlich sind bisher bekannte thermische Abtrennvorrichtungen für den Schutz von Überspannungselementen bei deren Überlastung ausreichend sensibel zu gestalten, wobei jedoch eine Beeinflussung durch umgebende Wärmequellen anderer elektronischer Baugruppen oder elektronischer Bauelemente möglichst ausgeschlossen werden soll.

Aus dem Vorgenannten ist es daher Aufgabe der Erfindung, eine weiterentwickelte Überspannungsschutzanordnung mit mehreren, auf einer ersten Seite einer n-eckigen Trägerplatte angeordneten, scheibenförmigen Varistoren sowie mindestens einem Gasableiter sowie thermischen Abtrenneinrichtungen anzugeben, welche in einfacher Weise mit wenigen Bauteilen, reduziertem Bauraum und kostengünstig herstellbar ist. Die zu schaffende Anordnung soll als kompakte Baugruppe so ausgeführt werden, dass sie zur unmittelbaren Montage auf einer Leiterplatte einsetzbar ist. Weiterhin soll die Möglichkeit bestehen, mit einfachen Mitteln erkennen zu lassen, ob die Anordnung funktionsfähig oder ob bereits eine Schädigung durch thermische Überlastung aufgetreten ist.

Die Lösung der Aufgabe der Erfindung erfolgt gemäß der Merkmalskombination nach Anspruch 1, wobei die Unteransprüche mindestens zweckmäßige Ausgestaltungen und Weiterbildungen umfassen.

Die erfindungsgemäße Lösung geht von einer an sich bekannten Überspannungsschutzanordnung aus, welche mehrere, auf einer ersten Seite einer n-eckigen Trägerplatte angeordneten, scheibenförmigen Varistoren aufweist. Die Überspannungsschutzanordnung besitzt darüber hinaus noch mindestens einen Gasableiter sowie thermischen Abtrenneinrichtungen. Die thermischen Abtrenneinrichtungen stehen in bekannter Weise mit den Varistoren in engem thermischen Kontakt.

Die vorgenannten Bauteile sind von einem Außengehäuse, das als Kappe ausgebildet sein kann, umgeben. Auf der zweiten Seite der Trägerplatte sind Mittel zum elektrischen Anschluss, z.B. ausgebildet als Kontaktstifte, vorhanden, die dem unmittelbaren Verlöten auf einer Leiterplatte dienen.

Erfindungsgemäß bilden die Varistoren eine dicht gepackte, parallele Anordnung, nachstehend als Paketanordnung bezeichnet. Diese Paketanordnung ist auf zwei gegenüberliegenden Seiten von je einer, auf der Trägerplatte aufsetzbaren oder mit dieser verbundenen, isolierenden Trennwand begrenzt.

Die Innenseite der Trennwand steht also mit der Paketanordnung in Verbindung. Jede Trennwand weist mindestens einen Durchbruch für einen Varistoranschluss auf, welcher mit je einer thermischen Abtrenneinrichtung in Verbindung steht, die wiederum einen federbelasteten Abtrennhebel umfasst. Es nimmt also die Außenseite der Trennwand die eigentliche thermische Abtrenneinrichtung auf. Der jeweilige Abtrennhebel ist an seinem ersten Ende mit dem jeweiligen Varistoranschluss durch ein Lot verbunden. Mit seinem zweiten Ende geht der Abtrennhebel in einen der elektrischen Anschlüsse über, welcher diesbezüglich die Trägerplatte durchdringt.

Die thermischen Abtrenneinrichtungen besitzen darüber hinaus je einen isolierenden Schieber, dessen freies Ende auf den Abtrennhebel einwirkt, wobei der Schieber in Ausformungen der jeweiligen Seitenwand geführt ist. Diese Führung ist als Längsführung ausgebildet, so dass eine Verschiebebewegung des Schiebers in Richtung Abtrennhebel erfolgen kann.

Die Lageveränderung des Schiebers, der z.B. als ein farblich gestaltetes Kunststoffbauteil ausgeführt sein kann, ist mittels einer Sichtöffnung im Außengehäuse erkennbar, so dass auf den Zustand der im Außengehäuse befindlichen Überspannungsschutzanordnung geschlossen werden kann.

Bei einer bevorzugten Ausführungsform der Erfindung besteht die Paketanordnung aus drei, mit ihren Längsseiten aneinander anliegenden Varistoren.

Erfindungsgemäß weist der Schieber zwei Zapfen zur führenden Aufnahme von jeweils einem Federelement auf, wobei die Zapfen parallel verlaufen. Die Zapfen nehmen jeweils eine Schraubenfeder auf, so dass die notwendige Vorspannung des Schiebers in Richtung Abtrennhebel gegeben ist.

An einer trennwandfreien Seite der Anordnung befindet sich ein Gasableiter, welcher elektrisch mit der Varistor-Paketanordnung verschalten ist.

Erfindungsgemäß verfügt der Gasableiter über eine separate thermische und federkraftunterstützte Abtrenneinrichtung.

Der Außengehäuse ist in bevorzugter Weise mit Hilfe einer Snap-in-Rastanordnung mit der Trägerplatte verbindbar.

Die Abtrenneinrichtung für den Gasableiter weist auf einen Abtrennmechanismus einwirkende Torsionsfedern auf. Der Schieber greift mit seinem freien Ende in unmittelbarer Nähe der Lotverbindungsstelle zwischen Abtrennhebel und Varistoranschluss an.

Ein besonderer Aspekt der Erfindung besteht darin, dass die vorstehend erläuterte thermische Abtrenneinrichtung doppelt und symmetrisch ausgebildet ist, das heißt, dass quasi auf beiden Außenseiten der erläuterten Trennwände entsprechende Abtrenneinrichtungen je für den L/N- und N/L-Zweig realisiert werden.

In weiterer Ausgestaltung der Erfindung erstrecken sich von der ersten Seite der Trägerplatte in Abschnitte des umschlossenen Raumes hinein Stegflächen zum Gewährleisten ausreichender elektrischer Trennungsabstände.

Das Außengehäuse kann die Form eines n-eckigen Würfels oder Quaders aufweisen.

In einer Ausgestaltung besitzt die Innwandung des Außengehäuses eine Wärmestrahlung-reflektierende Beschichtung oder weist Wärmestrahlung-reflektierende Eigenschaften auf. Damit ist sichergestellt, dass die thermische Abtrenneinrichtung primär auf im Gehäuse befindliche Wärmequellen und nicht auf externe Wärmequellen reagiert bzw. anspricht.

Die erläuterte Überspannungsschutzanordnung findet insbesondere Verwendung als kompakte, gekapselte Leiterplatten-montierbare Baueinheit, wobei die Größe der Kapselung im Wesentlichen von den Abmessungen der eingesetzten Varistoren, die das Paket bilden, bestimmt und vorgegeben ist.

Die Erfindung soll nachstehend anhand von Ausführungsbeispielen sowie unter Zuhilfenahme von Figuren näher erläutert werden.

Hierbei zeigen:
- Fig. 1: ein Prinzipschaltbild der Überspannungsschutzanordnung mit drei Varistoren und einem Gasableiter und den jeweiligen Pfaden;
- Fig. 2: eine perspektivische Darstellung der ersten Ausführungsform der Erfindung mit abgenommenem Außengehäuse;
- Fig. 3: eine perspektivische Explosionsdarstellung einer ersten Ausführungsform der Erfindung mit paralleler Paketanordnung von Varistoren sowie einem Gasableiter, welcher wie die Varistoren über eine separate thermische Abtrenneinrichtung verfügt;
- Fig,. 4: eine perspektivische Darstellung der ersten Ausführungsform mit Niedrigtemperatur-Lotverbindung der Abtrennvorrichtung im L/N-Pfad im geschlossenen Zustand;
- Fig. 5: eine Darstellung gemäß derjenigen nach Fig. 4, jedoch im abgetrennten Zustand 19 des L/N-Pfades;
- Fig. 6: eine perspektivische Darstellung der ersten Ausführungsform der Erfindung mit Niedrigtemperatur-Trennstrecke im N/L-Pfad im nicht abgetrennten Zustand 18';
- Fig. 7: eine Darstellung ähnlich derjenigen nach Fig. 6, jedoch im abgetrennten Zustand 19' des Pfades N/L;
- Fig. 8: eine perspektivische Darstellung der ersten Ausführungsform der Erfindung mit thermischer Abtrennvorrichtung für den Gasableiter im geschlossenen Zustand;
- Fig. 9: eine Darstellung ähnlich derjenigen nach Fig. 8, jedoch im abgetrennten Zustand 15' (Pfeildarstellung);
- Fig. 10: ein Prinzipschaltbild einer Ausführungsform der Überspannungsschutzanordnung mit thermischer Abtrenneinrichtung nur für die Varistoren, d.h. ohne thermische Abtrennung des Gasableiters und die Beschaltung in den Pfaden L/N, N/L und PE;
- Fig. 11: eine perspektivische Darstellung der zweiten Ausführungsform, die einen Gasableiter ohne separate thermische Abtrennvorrichtung zeigt und die kein Teil der Erfindung ist.
- Fig. 12: eine perspektivische Explosionsdarstellung der Ausführungsform mit einem Gasableiter ohne separate thermische Abtrenneinrichtung;
- Fig. 13: eine Darstellung gemäß zweiter Ausführungsform mit geschlossener thermischer Abtrennvorrichtung 230 im L/N-Pfad;
- Fig. 14: eine Darstellung ähnlich derjenigen nach Fig. 13, jedoch im abgetrennten Zustand 240 (Pfeildarstellung) des L/N-Pfades;
- Fig. 15: eine perspektivische Darstellung der Abtrennvorrichtung gemäß der zweiten Ausführungsform mit geschlossener Abtrennvorrichtung 230' im N/L-Pfad und
- Fig. 16: eine Darstellung ähnlich derjenigen nach Fig. 15, jedoch im abgetrennten Zustand 240' des N/L-Pfades.

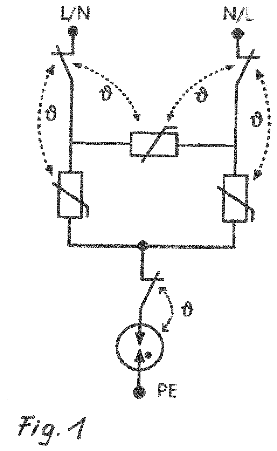

Die Fig. 1 zeigt ein Prinzipschaltbild der ersten Ausführungsform der Erfindung mit drei Varistoren und einem Gasableiter, wobei im L/N-Pfad sowie im N/L-Pfad jeweils eine thermische Abtrennvorrichtung für die Varistoren und in Richtung PE eine thermische Abtrennvorrichtung für den Gasableiter vorhanden ist. Die ab trennseitig energetische Einwirkung der Varistoren auf die entsprechenden Abtrennvorrichtungen im Zweig L/N bzw. N/L ist mit den symbolischen gestrichelten Pfeildarstellungen gezeigt und in analoger Weise bezogen auf den Gasableiter in Richtung PE symbolisiert.

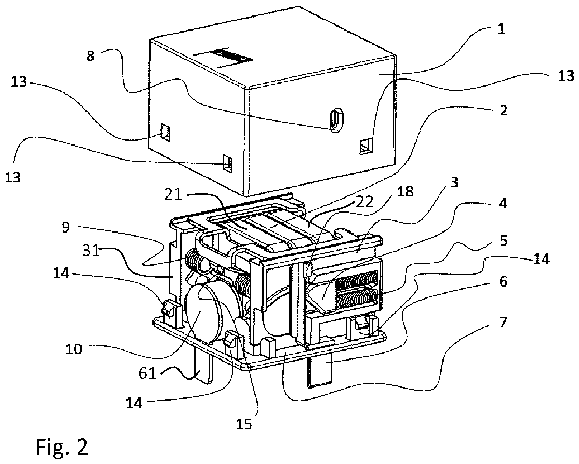

Die Überspannungsschutzanordnung nach den Fig. 2 und 3 sowie 11 uns 12 geht zunächst von einer Trägerplatte 7 aus.

Diese Trägerplatte 7 besteht aus einem Kunststoff-Spritzgussmaterial. In der Trägerplatte 7 sind schlitzförmige Öffnungen 72 eingebracht, die der Durchführung von Anschlüssen 6 und 61 dienen.

Die entsprechenden durchgeführten Anschlüsse 6 und 61 können zur unmittelbaren Kontaktierung und dem Verlöten auf einer Leiterplatte (nicht gezeigt) genutzt werden.

Die Überspannungsschutzanordnung nach den Fig. 2; 3 und 11; 12 umfasst darüber hinaus eine Ausbildung mehrerer scheibenförmiger Varistoren 2; 21; 22. Diese Varistoren bilden eine parallele Paketanordnung.

Diese parallele Paketanordnung ist auf zwei gegenüberliegenden Seiten von je einer, auf der Trägerplatte 7 aufsetzbaren isolierenden Trennwand 3; 31 begrenzt.

Jede Trennwand 3; 31 besitzt mindestens einen Durchbruch für einen Varistoranschluss 62, welcher mit je einer thermischen Abtrenneinrichtung in Verbindung steht.

Diese thermischen Abtrenneinrichtungen verfügen über einen federbelasteten Abtrennhebel 80.

Der jeweilige Abtrennhebel 80 ist an seinem ersten Ende mit dem jeweiligen Varistoranschluss 62 durch Lot 18 im L/N-Pfad bzw. N/L-Pfad 20 verbunden.

An seinem zweiten Ende geht der jeweilige Abtrennhebel 80 in einen der elektrischen Anschlüsse 6 (L/N-Pfad) über, welcher die Trägerplatte 7 durchdringt.

Die thermische Abtrenneinrichtung umfasst darüber hinaus einen isolierenden Schieber 4, dessen freies Ende auf den Abtrennhebel 80 einwirkt, wobei der Schieber 4 in Ausformungen 81 der jeweiligen Trennwand 3 geführt ist.

Eine Lageveränderung des Schiebers 4 ist mittels einer Sichtöffnung in Form eines Fensters 8 im Außengehäuse 1 erkennbar.

Der Schieber 4 umfasst weiterhin zwei Zapfen zur führenden Aufnahme von jeweils einer Schraubenfeder 5.

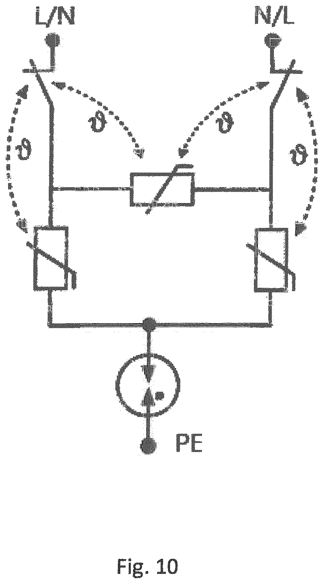

An ihrer trennwandfreien Seite weist die Anordnung einen Gasableiter 10 auf, welcher elektrisch mit der Varistor-Paketanordnung gemäß Fig. 1 bzw. Fig. 10 nach der zweiten Ausführungsform verschalten ist.

Der Gasableiter 10 verfügt über eine separate thermische und federkraftunterstützte Abtrenneinrichtung.

Diesbezüglich weist die Abtrenneinrichtung für den Gasableiter 10 zwei Torsionsfedern 9 auf.

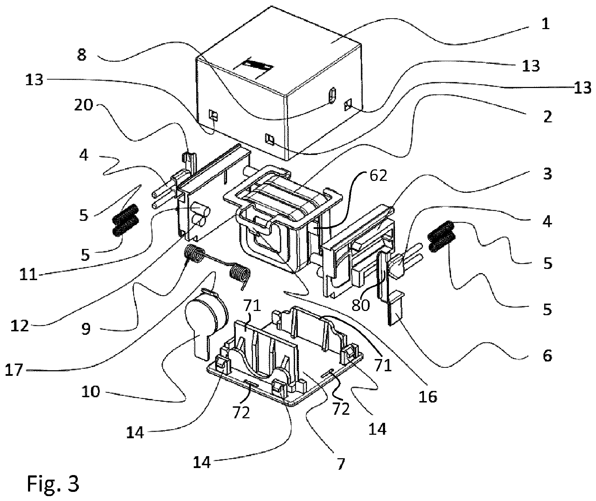

Wie aus den Fig. 2 und 3 ersichtlich, greift der Schieber 4 in unmittelbarer Nähe der Lotverbindungsstelle zwischen Abtrennhebel 80 und Varistoranschluss 62 an. Die Fig. 2 und 3 zeigen noch Aussparungen 13 im Außengehäuse 1. Die Aussparungen dienen der Aufnahme von Rasthaken 14 zur Bildung einer Snap-in-Verbindung. Mit dem Bezugszeichen 10 ist die Niedrigtemperatur-Lotverbindung der Abtrennvorrichtung für den Gasentladungsableiter und mit dem Bezugszeichen 18 die entsprechende Niedrigtemperatur-Lotverbindung für die Abtrennvorrichtung der Varistoren symbolisiert. Die Torsionsfedern 9 gemäß Fig. 3 werden von den Achsstummeln 11 und 12 vorgespannt und geführt. Mit dem Bezugszeichen 16 wird die Trennstellenelektrode varistorseitig und mit dem Bezugszeichen 17 die Trennstellenelektrode gasentladungsableiterseitig bezeichnet.

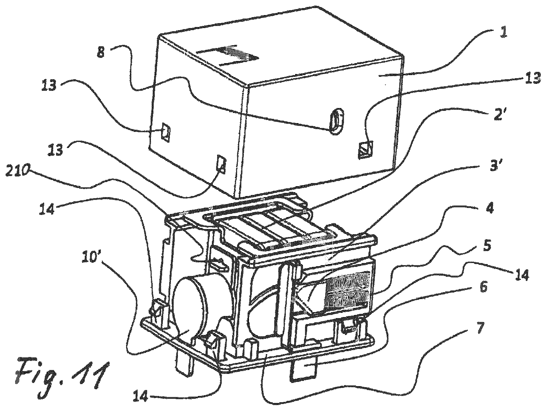

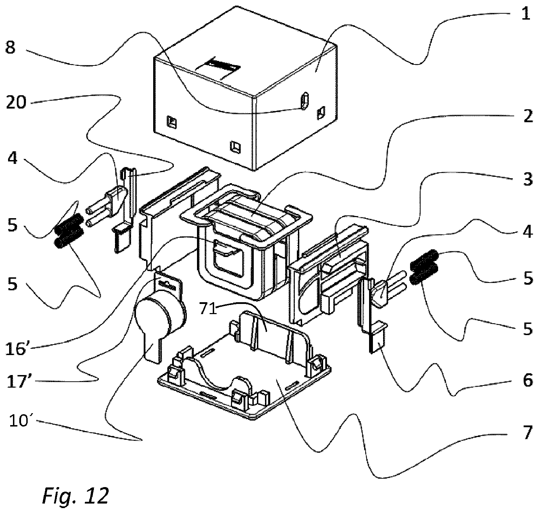

Die Darstellung gemäß Fig. 11 und 12 umfasst eine vergleichbare Ausführungsform wie anhand der Fig. 2 und 3 erläutert, mit dem Unterschied, dass der Gasableiter 10 gemäß Fig. 11 und 12 über keine separate thermische Abtrenneinrichtung mit entsprechendem Kontaktbügel und Torsionsfeder 9 verfügt.

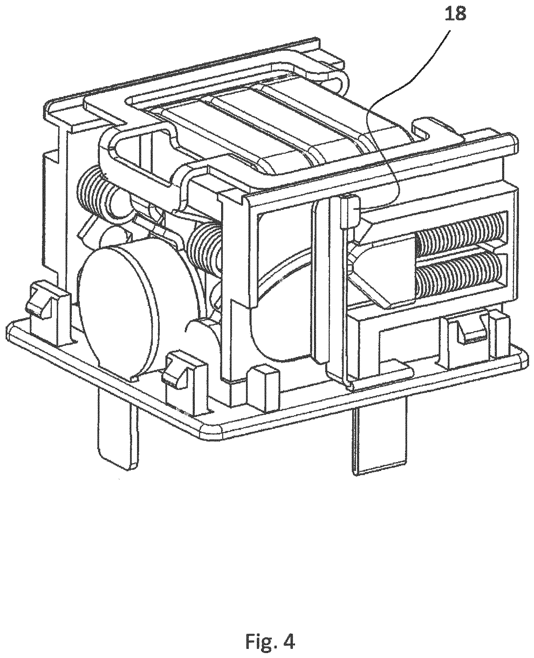

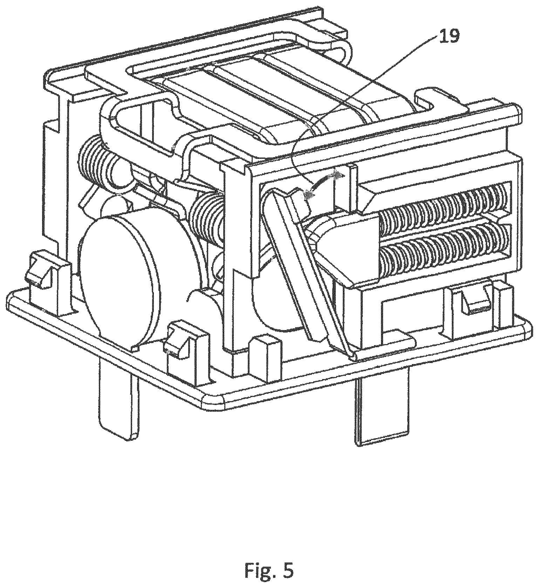

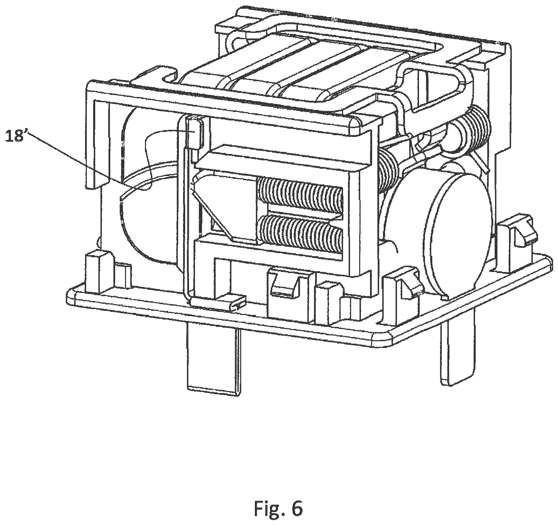

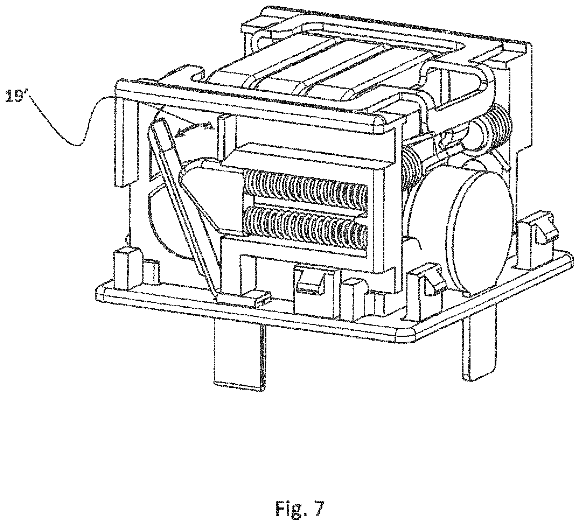

In den Fig. 4 und 6 ist die thermische Abtrenneinrichtung für die Varistoren im geschlossenen Zustand und in den Fig. 5 und 7 im geöffneten, d.h. abgetrennten Zustand dargestellt.

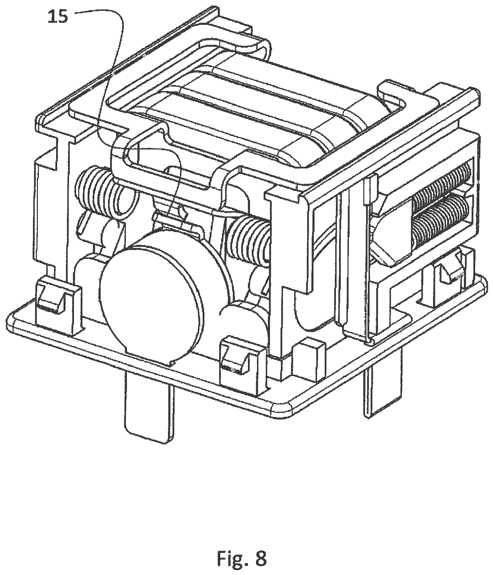

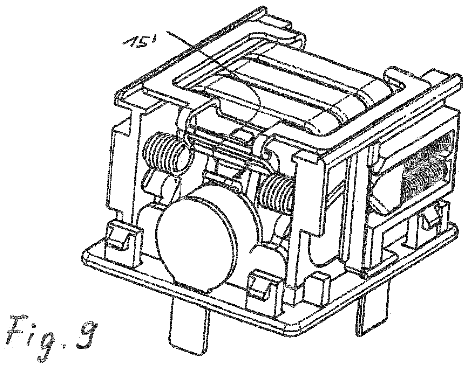

Die Fig. 8 zeigt den Zustand der nicht abgetrennten thermischen Abtrennvorrichtung für den Gasentladungsableiter 10 und die Fig. 9 den diesbezüglich abgetrennten Zustand 15'.

Die Fig. 10 zeigt das Schaltbild der inneren Verdrahtung gemäß der zweiten Ausführungsform, die kein Teil der Erfindung ist, wobei bei dieser Ausführungsform der in PE-Richtung liegende Gasableiter keine separate Abtrennvorrichtung besitzt. Vielmehr findet hier ein normales Verlöten 210 an der entsprechenden Kontaktstelle statt. Der Aufbau der übrigen Baugruppen, insbesondere der thermischen Abtrennvorrichtungen für die Varistoren 2 entspricht derjenigen gemäß der ersten Ausführungsform.

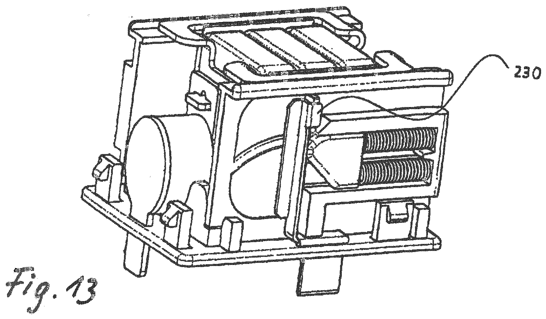

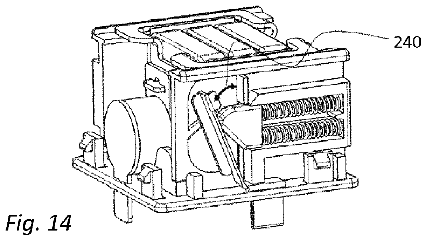

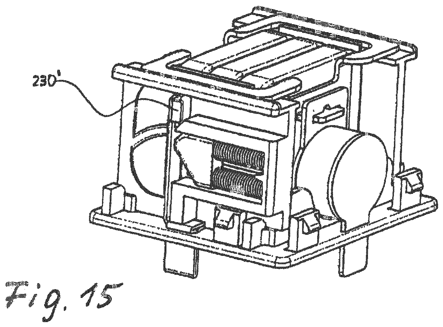

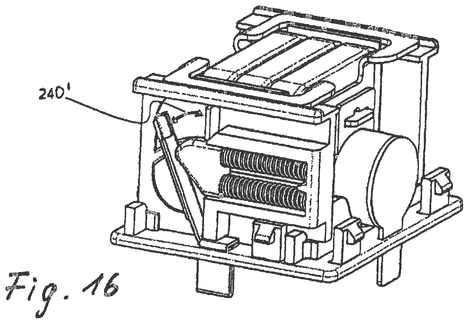

Der nicht abgetrennte Zustand 230 und 230' ist in den Fig. 13 und 15 und der abgetrennte Zustand 240 und 240' in den Fig. 14 und 16 dargestellt.

Die Lotverbindung des Gasableiters 10' gemäß zweiter Ausführungsform mit der Elektrode 16' des entsprechenden Varistors 2 wird unterstützt durch eine schlitzförmige Ausnehmung im Anschlussteil 17' des Gasableiters 10'.

Die Innenwandung des Außengehäuses 1 kann noch eine Wärmestrahlungsreflektierende Beschichtung aufweisen und ansonsten thermisch und elektrisch isolierend ausgebildet sein.

## Patentansprüche

1. Überspannungsschutzanordnung mit mehreren, auf einer ersten Seite einer n-eckigen Trägerplatte (7) angeordneten, scheibenförmigen Varistoren (2; 21; 22), mindestens einem Gasableiter (10) sowie thermischen Abtrenneinrichtungen, welche mit den Varistoren in engem thermischen Kontakt stehen, wobei die vorgenannten Bauteile von einem Außengehäuse (1) umgeben und weiterhin auf der zweiten Seite der Trägerplatte (7) Mittel zum elektrischen Anschluss zum Verlöten auf einer Leiterplatte vorgesehen sind, wobei die Varistoren (2; 21; 22) eine parallele Paketanordnung bilden, welche auf zwei gegenüberliegenden Seiten von je einer, auf der Trägerplatte (7) aufsetzbaren, isolierenden Trennwand (3; 31) begrenzt ist,
jede Trennwand (3: 31) mindestens einen Durchbruch für einen Varistoranschluss (62) aufweist, welcher mit je einer thermischen Abtrenneinrichtung in Verbindung steht, die wiederum einen federbelasteten Abtrennhebel (80) umfasst, wobei der jeweilige Abtrennhebel (80) an seinem ersten Ende mit dem jeweiligen Varistoranschluss (62) durch ein Lot verbunden ist und mit seinem zweiten Ende in einen der elektrischen Anschlüsse (6) übergeht und diesbezüglich die Trägerplatte (7) durchdringt, weiterhin
die thermischen Abtrenneinrichtungen je einen isolierenden Schieber (4) besitzen, dessen freies Ende auf den jeweiligen Abtrennhebel (80) einwirkt,
**dadurch gekennzeichnet, dass**
die Schieber (4) in Ausformungen (81) der jeweiligen Trennwand (3; 31) geführt sind und eine Lageveränderung des Schiebers (4) mittels einer Sichtöffnung (8) im Außengehäuse (1) erkennbar ist, die Schieber (4) zwei Zapfen zur führenden Aufnahme von jeweils einem Federelement (5) besitzen, wobei die Zapfen parallel verlaufen und an einer trennwandfreien Seite der Gasableiter (10) befindlich ist, welcher elektrisch mit der Varistor-Paketanordnung verschalten ist und welcher über eine separate thermische und federkraftunterstützte Abtrenneinrichtung mit auf Achsstummeln (11; 12) vorgespannten und geführten Torsionsfedern (9) verfügt.

2. Überspannungsschutzanordnung nach Anspruch 1,
**dadurch gekennzeichnet, dass**
die Paketanordnung aus drei, mit ihren Längsseiten aneinander liegenden Varistoren (2; 21;22) gebildet ist.

3. Überspannungsschutzanordnung nach einem der vorangegangenen Ansprüche,
**dadurch gekennzeichnet, dass**
das Außengehäuse (1) mittels Snap-in-Rastanordnung (13; 14) mit der Trägerplatte (7) verbindbar ist.

4. Überspannungsschutzanordnung nach einem der vorangegangenen Ansprüche,
**dadurch gekennzeichnet, dass**
der Schieber (4) in unmittelbarer Nähe der Lotverbindungsstelle zwischen Abtrennhebel (80) und Varistoranschluss (62) angreift.

5. Überspannungsschutzanordnung nach einem der vorangegangenen Ansprüche,
**dadurch gekennzeichnet, dass**
sich von der ersten Seite der Trägerplatte (7) in Abschnitte des umschlossenen Raumes hinein Stegflächen (71) zum Gewährleisten ausreichender elektrischer Trennungsabstände erstrecken.

6. Überspannungsschutzanordnung nach einem der vorangegangenen Ansprüche,
**dadurch gekennzeichnet, dass**
die Innenwandung des Außengehäuses (1) eine Wärmestrahlung-reflektierende Beschichtung oder Wärmestrahlung-reflektierende Eigenschaften besitzt.

7. Überspannungsschutzanordnung nach einem der vorangegangenen Ansprüche, **gekennzeichnet durch** deren Einsatz als kompakte, gekapselte Leiterplatten-montierbare Einheit, wobei die Größe der Kapselung im Wesentlichen von den Abmessungen der eingesetzten Varistoren bestimmt und vorgegeben ist.

## Claims

1. An overvoltage protection arrangement having a plurality of disc-shaped varistors (2; 21; 22) arranged on a first side of an n-cornered supporting plate (7), at least one gas arrester (10), as well as thermal disconnecting devices being in close thermal contact with the varistors, wherein the aforementioned components are surrounded by an outer casing (1), and furthermore means for the electrical connection for soldering onto a printed circuit board are provided on the second side of the supporting plate (7), wherein the varistors (2; 21; 22) form a parallel package arrangement delimited at two opposing sides by in each case one insulating partition (3; 31) attachable to the supporting plate (7),
each partition (3; 31) has at least one breakthrough for a varistor connection (62) which is associated in each case with one thermal disconnecting device, which in turn comprises a spring-loaded disconnecting lever (80), wherein the respective disconnecting lever (80), at its first end, is associated with the respective varistor connection (62) by solder, and merges with its second end into one of the electrical connections (6) and penetrates the supporting plate (7) in this respect, furthermore the thermal disconnecting device each have an insulating slide (4), the free end of which acts upon the respective disconnecting lever (80),
**characterized in that**
the slides (4) are guided in forms (81) of the respective partition (3; 31), and a positional change of the slide (4) is recognizable by means of a view opening (8) in the outer casing (1), the slides (4) have two pins for receiving in each case one spring element (5) in a guiding manner, wherein the pins run in parallel, and the gas arrester (10) is located on a side which is free from any partition and is electrically interconnected to the varistor package arrangement and disposes of a separate thermal and spring force-assisted disconnecting device having torsion springs (9) pretensioned and guided on axle stubs (11; 12).

2. The overvoltage protection arrangement according to claim 1,
**characterized in that**
the package arrangement is formed by three varistors (2; 21; 22) lying next to each other with their longitudinal sides.

3. The overvoltage protection arrangement according to any one of the preceding claims,
**characterized in that**
the outer casing (1) is connectable to the supporting plate (9) by means of a snap-in latching arrangement (13; 14).

4. The overvoltage protection arrangement according to any one of the preceding claims,
**characterized in that**
the slide (4) engages in the direct vicinity of the solder joint between the disconnecting lever (80) and the varistor connection (62).

5. The overvoltage protection arrangement according to any one of the preceding claims,
**characterized in that**
web surfaces (71) extend from the first side of the supporting plate (7) into sections of the enclosed space for ensuring sufficient electrical separating distances.

6. The overvoltage protection arrangement according to any one of the preceding claims,
**characterized in that**
the inner wall of the outer casing (1) has a heat radiation reflecting coating or has heat radiation reflecting properties.

7. The overvoltage protection arrangement according to any one of the preceding claims, **characterized by** its use as a compact, encapsulated unit that can be mounted on a printed circuit board, wherein the size of the encapsulation is substantially determined and specified by the dimensions of the employed varistors.

## Revendications

1. Dispositif de protection contre les surtensions comportant plusieurs varistances (2 ; 21 ; 22) en forme de disque disposées sur une première face d'une plaque de support (7) à n coins, au moins un dérivateur à gaz (10) et des moyens de coupure thermique qui sont en contact thermique intime avec les varistances, les composants précités étant entourés par un boîtier extérieur (1) et, en outre, des moyens de liaison électrique pour le soudage à une carte de circuit étant prévus sur la deuxième face de la plaque de support (7), les varistances (2 ; 21 ; 22) formant un ensemble empilé parallèle qui est délimité sur deux côtés opposés par une cloison de séparation isolante (3 ; 31) qui peut être placée sur la plaque de support (7),
dans lequel
chaque cloison de séparation (3 ; 31) présente au moins une traversée pour une connexion de varistance (62), qui est reliée à un moyen de déconnexion thermique respectif, qui à son tour comprend un levier de déconnexion (80) chargé par ressort, le levier de déconnexion respectif (80) étant relié par sa première extrémité à la connexion de varistance respective (62) par un apport de brasage et se transformant par sa deuxième extrémité en l'une des bornes électriques (6) et traversant à cet effet la plaque de support (7),
les moyens de coupure thermique comportent chacun un curseur isolant (4) dont l'extrémité libre agit sur le levier de coupure respectif (80),
**caractérisé en ce que**
les curseurs (4) sont guidés dans des conformations (81) de la cloison de séparation respective (3 ; 31) en permettant de reconnaître un changement de position du curseur (4) au moyen d'une ouverture de visualisation (8) dans le boîtier extérieur (1),
les curseurs (4) possèdent deux broches pour recevoir en guidage un élément à ressort respectif (5),
les broches s'étendent parallèlement, et
le dérivateur à gaz (10) se situe sur un côté dépourvu de cloison de séparation et est branché électriquement à l'ensemble empilé de varistances et dispose d'un moyen séparé de séparation thermique assisté par la force de ressorts, ayant des ressorts de torsion (9) précontraints et guidés sur des moignons d'axe (11 ; 12).

2. Dispositif de protection contre les surtensions selon la revendication 1,
**caractérisé en ce que**
l'ensemble empilé est formé par trois varistances (2 ; 21, 22) dont les côtés longitudinaux s'appliquent les uns contre les autres.

3. Dispositif de protection contre les surtensions selon l'une des revendications précédentes,
**caractérisé en ce que**
le boîtier extérieur (1) peut être relié à la plaque de support (7) au moyen d'un dispositif d'encliquetage (13 ; 14).

4. Dispositif de protection contre les surtensions selon l'une des revendications précédentes,
**caractérisé en ce que**
le curseur (4) attaque à proximité immédiate de l'emplacement de liaison brasée entre le levier de déconnexion (80) et la connexion de varistance (62).

5. Dispositif de protection contre les surtensions selon l'une des revendications précédentes,
**caractérisé en ce que**
des surfaces d'âme (71) s'étendent depuis le premier côté de la plaque de support (7) jusque dans des portions de l'espace enfermé pour assurer des distances de séparation électrique suffisantes.

6. Dispositif de protection contre les surtensions selon l'une des revendications précédentes,
**caractérisé en ce que**
la paroi intérieure du boîtier extérieur (1) possède un revêtement réfléchissant le rayonnement thermique ou des propriétés de réflexion du rayonnement thermique.

7. Dispositif de protection contre les surtensions selon l'une des revendications précédentes,
**caractérisé par** son utilisation en tant qu'unité compacte, encapsulée, pouvant être montée sur une carte de circuit, la taille de l'encapsulage étant essentiellement déterminée et prédéfinie par les dimensions des varistances utilisées.
